# EUROPEAN PATENT SPECIFICATION

(11) **EP 4 578 252 B1**
(45) Date of publication and mention of the grant of the patent: **29.04.2026**
(21) Application number: 23761128.0
(22) Date of filing: 24.08.2023
(51) Int. Cl.: G06F 1/20, H05K 7/20

(54) **COLD PLATE ASSEMBLY FOR LIQUID COOLING OF ELECTRONIC DEVICES**
KÜHLPLATTENANORDNUNG ZUR FLÜSSIGKEITSKÜHLUNG ELEKTRONISCHER VORRICHTUNGEN
ENSEMBLE PLAQUE FROIDE POUR REFROIDISSEMENT LIQUIDE DE DISPOSITIFS ÉLECTRONIQUES

(30) Priority: 24.08.2022 DK PA202200782
(43) Date of publication of application: 02.07.2025
(73) Proprietor: Asetek Danmark A/S, 9230 Svenstrup J (DK)
(72) Inventor: SAKSAGER, Anders Hjørringgaard, 9260 Gistrup (DK)
(74) Representative: Patrade A/S
(86) International application number: PCT/EP2023/073271
(87) International publication number: WO 2024/042182

(56) References cited:
- EP-A1- 3 907 584
- US-A1- 2005 151 244
- US-A1- 2009 284 921
- US-A1- 2020 227 341
- US-A1- 2022 117 115

## Description

### FIELD OF THE INVENTION

The invention relates to liquid cooling of electronic devices, in particular processing units of computer devices, and how to design a cold plate assembly for individual computer chips.

### BACKGROUND

Effective cooling of electronic devices such as computers and servers has become very important as modern computing systems have an increasing power density. The number of primary heat sources in an electronic device like a central processing unit or a graphics processing unit tend to increase due to a demand for more computing power. Furthermore, computing devices can be thermally throttled if the temperature gets too high locally. For these reasons it is very important to be able to cool computing devices effectively and such that the electronic devices can continue to run and execute complicated tasks.

Secondary heat sources are cooled using passive cooling. This is done by using heat sinks the size of which depends on the power density. When the power density grows the heat sinks become very large and thus not practical to use anymore and another technique is needed.

For electronic devices with high power densities active cooling is used. Active cooling uses normally either air cooling or liquid cooling. Air cooling uses fans and airflow to transport heat away from the electronic device and therefore needs a path for a good airflow to be efficient. As these electrical devices are packed closely together the air flow can get restricted by other devices, their cooling system, and other internal structures and thereby the cooling becomes less efficient. For this reason liquid cooling is used to cool electronic devices that are densely packed. Liquid cooling is a technique that can cool efficiently and take up less space locally than air cooling.

For liquid cooling a cold plate is used to exchange heat away from the device that needs cooling. The heat is then exchanged to a liquid inside the cold plate and transported away to a radiator where the liquid is cooled and made ready for being pumped back into the cold plate again to cool the cold plate once more. Liquid is used for cooling as the heat capacity is for many liquids much larger than that of air.

In liquid cooling systems it is difficult to create an effective heat exchange from the cold plate to the liquid. This needs to be done without losing too much pressure through the system while keeping the liquid flow high enough. The surface area of the channels in the cold plate is the place where the heat is exchanged from the cold plate to the liquid. The larger a surface area the better heat transfer will be. As the surface area of the channels in the cold plate increases, the flow resistance also increase and this limits the flow through the cold plate. There are more parameters that effects the cooling of a cold plate such as placement and size of channels and slots, number of channels and slots, and materials.

Previous liquid cooling has been done by cooling all over the cold plate as for example disclosed in EP3907584A1. Further prior art is disclosed in US2009/284921 A1 and US2005/151244 A1.

The invention disclosed in EP3907584A1 is a cold plate assembly for use in a liquid cooling system for cooling a computing device including a method comprising:
- providing a heat map of a computing system with at least two different electrical components mutually spaced apart and having two different heat generation rates, the thermal map mapping the relative heat generation of said at least two electrical components as well as their relative locations,
- providing a template cold plate assembly design,
- modifying said template design by mutually adapting parameters relating to the inlet manifold, the inlet slots, the chamber, the fins, the outlet slots and the outlet manifold to achieve a cooling profile of the cold plate exterior surface that matches the thermal map of the computing system, and
- producing a cold plate assembly according to the modified template design.

Known cold plates are designed to direct the flow of liquid evenly over an area to be cooled at an optimised rate. However, once the liquid has passed the warmest areas and the temperature has increased the efficiency of the cooling is lowered thereby decreasing the efficiency of the cooling effect, making it inefficient for closely packed heat generating components with an uneven heat production.

### SUMMARY OF THE INVENTION

The invention is as set out in the independent claim. Preferable features of the invention are defined in the appended dependent claims.

A first aspect of the present disclosure is:
A cold plate assembly for use in a liquid cooling system for cooling of a computing device having a plurality of active regions from which heat is dispersed with varying intensity ranging from one or more high-intensity zones to one or more low-intensity zones, the cold plate assembly comprising:
A cold plate for exchanging heat between the computing device and cooling liquid of the liquid cooling system, the cold plate comprising an exterior surface for facing the computing device and an opposite inner surface adapted to be in contact with the cooling liquid, the inner surface further comprising guiding means for guiding the cooling liquid along the inner surface in a predefined pattern focusing the liquid flow across one or more predefined high-priority zones
a distribution layer configured to be mounted onto the inner surface of the cold plate, the distribution layer comprising a
   - liquid inlet through which the inner surface of the cold plate receives cooling liquid from the liquid cooling system, and a
   - liquid outlet through which cooling liquid is discharged away from the inner surface into the liquid cooling system,
the liquid inlet being in liquid communication with an inlet channel, the inlet channel and the liquid outlet being in liquid communication with an outlet channel,
such that the flow of liquid is directed across the cold plate from the inlet channel to the outlet channel, via the guiding means, the inlet channel being arranged such that it is at least partially coinciding with a high-intensity zone of the computing device when the cold plate assembly is arranged to cool said computing device.

Thereby heat from the computing device is transferred into the cooling liquid. A contributing factor to the efficient heat transfer is the guiding means providing the cold plate with a large surface area where the heat can be transferred. By cooling a computing device more tasks can be executed by the computing device without risking overheating of the active components and therefore it can run faster.

By a computing device is understood a device comprising one or more chips. A computing device may for example comprise electronic circuits. A computing device may be a single active component or it may be an integrated circuit comprising multiple active components. Such computing devices will generate heat when processing data. For many computing devices heat generation does not occur uniformly, e.g. in an integrated circuit there will be spacing between the active components of a chip and no heat is generated in such spaces. The locations on a computing device generating heat are described as active regions. Heat will disperse from such active regions throughout the computing device.

By a high-intensity zone is understood a zone of the computing device corresponding to a high temperature generated by an active region. A high-intensity zone is thus likely to coincide with an active region. By high-intensity is thus understood a high heat flux. The span which is considered high-intensity may vary for different embodiments of the invention. By a high-intensity zone is understood an area being within the highest predefined fraction of heat flux found across the computing device. For example in some variants high-intensity zones may include areas wherein the heat flux is within the highest 10% of heat flux of the computing device.

By a low-intensity zone is understood a zone of the computing device corresponding to little to no heat being generated by the computing device. A low-intensity zone is thus likely to be located away from active regions of the computing device or to coincide with active regions generating less heat than other active regions of the same computing device. By a low-intensity zone is understood an area being within the lowest predefined fraction of heat flux found across the computing device. For example in some variants low-intensity zones may include areas wherein the heat flux is within the lowest 50% of heat flux of the computing device.

By guiding means is understood any form of one or more channels that can direct a flow of liquid though the guiding means. Guiding means can be straight channels or be bend such that the guiding means have an arbitrary shape. One example of guiding means could be microchannels, as they can direct a liquid flow. Hereafter guided means and microchannels will be used to interchangeably.

In a variant of the cold plate assembly at least one of the one or more predefined high-priority zones coincide with one of the one or more high-intensity zones of the computing device when the cold plate assembly is arranged to cool the computing device.

By making the high-priority zones coincide with one or more of the high-priority zones the cooling will be focused on the areas where the most heat is produced.

In a variant of the cold plate assembly at least one of the one or more predefined high-priority zones coincide with an active region of the computing device when the cold plate assembly is arranged to cool the computing device.

By having the high-priority zone coincide with the active region of the computing device it is ensure that the most cooling is done in the areas where heat is produced and where there are electronic components that can be protected by cooling.

In one variant of the cold plate assembly the high-intensity zones and the low-intensity zones will be delimited such that they cover all of the area of the computing device, e.g. the high-intensity zones include areas wherein the heat flux is within the 10% highest temperature flux of the computing device and thus the low-intensity zones must include all areas wherein the heat flux is within the 90% lowest heat flux of the computing device. In other variants there may be further intermediate-intensity zones.

It is to be understood that while the active regions are of the computing device, the high-intensity and low-intensity zones may be mapped into the cold plate as the cold plate contacting the computing device to be cooled will experience the same spatial distribution of the heat flux when the exterior surface of the cold plate contacts the computing device.

In order to define how much each area of the computing device is desired to be cooled, priority zones are used. By a high-priority zone is meant a zone that is desired to be cooled as much as possible; meaning that the temperature maximum or a temperature average should be minimised. By a low-priority zone is meant a zone where the temperature is desired to be kept under a certain temperature threshold. Different low-intensity zones may be defined by having a different temperature threshold value. It could be that a specific electrical part of the computing device would malfunction if the temperature exceeded e.g. 70 °C. In most cases the high-priority zone or zones will match the high-intensity zone or zones as this is the areas where the largest amount of heat is dispersed from the computing device. A high-priority zone may be placed in a low-intensity zone if e.g. at the location of sensitive electrical component or at components which will perform better the colder it is.

By having guiding means across high-intensity zones and placing the inlet channels at least partly on top of a high-intensity zone the heat is transported effectively away from the active areas, and less heat is transported away from other zones. Resulting in an effective differentiated cooling system.

The distribution layer ensures that the liquid enters through the inlet and is distributed from there. Moreover, the distribution layer contributes to making the system liquid tight to prevent leakage.

A variant of the cold plate assembly comprises a plurality of inlet channels connected in an inlet network and/or a plurality of outlet channels connected in an outlet network. By having multiple inlet channels cold liquid can be introduced close to the high-priority zones to cool effectively. Another effect is that the liquid flow path can be made shorter and thus causing less flow resistance and a faster flow of liquid.

Having a plurality of outlet channels contributes to keep a short liquid flow path and be able to transport hot liquid away from high-priority zones.

In a variant of the cold plate assembly, the inlet network and the outlet network are connected via microchannels.

By having microchannels there is a large surface area of the cold plate to transfer heat from the cold plate to the liquid, thus a good heat transfer between the cold plate and the cooling liquid is ensured.

In a variant of the invention the cold plate assembly comprises an inlet channel and an outlet channel being arranged on opposite sides of a local temperature maxima of an active region.

By placing the inlet and outlet channels on opposite sides of the local temperature maxima, cooling of the area with the local temperature maxima is ensured as the liquid will pass through the microchannels between the inlet and outlet channel. Furthermore placement on opposite sides, i.e. adjacent to the maxima rather than completely coincident with the temperature maxima ensures that at least part of the area to which heat radiates is cooled, this is relevant as the cold plate is temperature conducting and thus heat will spread in all directions around the temperature maxima.

In a variant of the invention the cold plate assembly has at least one inlet channel comprising a constriction such that the cross-sectional area of the inlet channel is larger at a first position than at a second position by tapering and/or stepwise decrease of the cross-sectional area.

By having a constriction in the inlet channel in the form of a tapered section or by a section having a step, the cooling of the computing device can be manipulated in a controlled manner. This is due to the flow resistance increases as the size of a channel decreases. Thereby the liquid flow can be controlled such that the flow is higher in some areas than other areas. This can be used to cool high-priority zones more than other zones such as low-priority zones.

In a variant of the invention, the cold plate assembly has the inlet channel comprised in both the distribution layer and the cold plate and/or an outlet channel being comprised in both the distribution layer and the cold plate.

When the inlet channel is comprised in both the cold plate and the distribution layer it is easier to design the system and make it liquid-tight.

In a variant of the invention all microchannels are arranged as part of the cold plate.

Arranging the microchannels may be done such that heat transfer from the cold plate to the liquid is maximised. For example confining the microchannels to the cold plate may be beneficial if the heat transferring capacity of the cold plate is better than that of the distribution layer. Only having microchannels in the cold plate may also make the cold plate assembly even more protected from leakage of liquid.

In a variant of the invention the cold plate assembly comprises a plurality of microchannels and/or inlet channels and/or outlet channels which are arranged in multiple layers on top of each other with respect to said exterior surface of said cold plate.

By having multiple channels on top of each other a better heat transfer may be obtained. Freer placement of channels also enables shortening flow paths.

In a variant the cold plate assembly comprises one or more microstructures protruding within one or more of the microchannels at least partly transverse to the direction of liquid flow within the microchannel.

By having microstructures protruding inside the microchannels the surface area of the cold plate can be increase and an increased surface area may lead to an increased heat transfer. Moreover, microstructures may introduce turbulence within the channels which may in turn also increase the heat transfer to the cooling liquid.

In a variant of the invention the cold plate assembly has a cold plate having been constructed via 3D-printing.

3D printing is a very versatile technique that can construct a lot of different shapes. This gives the possibility for all the channels to be designed and optimized for heat transfer. The channels can comprise bends and/or a lattice of metal through which the liquid flows. Introducing lattices int eh flow path may increase the heat transfer as the surface area of contact between the cold plate and the liquid is increased. Introducing bends and irregular shapes may be used to control the flow resistance. By designing every channel the cooling can be differentiated to fit a lot of different computing devices.

A second aspect of the present disclosure, not falling in the scope of the claims, is:
A method of designing a cold plate assembly comprising the steps of obtaining a surface temperature distribution map of a target computing device, defining a fixed inlet position and a fixed outlet position of the cold plate assembly, iteratively optimising the placement and/or number and/or dimensions of inlet channels, outlet channels and/or microchannels of the cold plate assembly to minimise the temperature simulated for the collective system of the cold plate assembly and computing device based on said surface temperature distribution map.

In a variant of the method the temperature which is being minimised during the optimization is the global temperature maximum or an average temperature such as the total average or the average temperature of the areas corresponding to the highest 10 % range of temperatures of the temperature distribution map.

In a variant the method further comprises the steps of
based on the surface temperature distribution map defining a plurality of priority zones according to predetermined temperature limits for each priority zone,
before optimising the cold plate assembly categorising said plurality of priority zones in at least two categories depending on the maximum surface temperature of each of the zones, one of the at least two categories being high-priority zones such that at least one high-priority zone is assigned, and
defining said high-priority zones as areas of temperature minimisation.

By dividing the area of the cold plate assembly into high-priority and low-priority zones it is chosen which areas of the computing device it is important to cool and which areas are less important.

In a variant of the method the area of the cold plate is defined as one high-priority zone such that this high-priority zone covers all of said heat map.

If the maximum global temperature of a computing device is to be minimised one high-priority zone may be used which covers all of the heat map. A high-intensity zone could have the criteria of minimising the global maximum temperature inside the zone. This may be done using a single function describing the heat map, i.e. a function describing the two-dimensional variations in the heat flux over the area of the computing device, if such a function can be obtained. If the heat map is described by multiple functions the area of the heat map may be divided into multiple priority zones. Description by multiple function may also include discretisation of the heat map and assigning a value indicative of the relative heat flux to each pixel, i.e. discrete segment, of the heat map.

In other words a variant of the method of designing a cold plate assembly comprises all the steps of
obtaining a surface temperature distribution map of a target computing device,
based on said surface temperature distribution map defining a plurality of priority zones according to predetermined temperature limits for each priority zone, categorising said plurality of priority zones in at least two categories depending on the maximum surface temperature of each of said zones, one of said at least two categories being high-priority zones such that at least one high-priority zone is assigned, defining a fixed inlet position and a fixed outlet position,
iteratively optimising the placement and/or number and/or dimensions of inlet channels, outlet channels and/or microchannels to minimise the temperature in said at least one high-priority zone.

In a variant of the method having one of said at least two categories being low-priority zones such that at least one low-priority zone is assigned, wherein the optimisation is restricted to maintain a maximum temperature of the low-priority zone below a predetermined threshold value.

To differentiate the cooling of the computing device it is important to have zones where cooling is not as important as in the high-priority zones. This is done by having low-priority zones where the temperature is kept under a certain threshold. The threshold may be chosen to ensure that no part of the computing device is overheated, e.g. based on which maximal operation temperature is acceptable for the computing device. This threshold may be set differently for different zones the importance of each zones can be chosen.

In a variant of the the method comprising more than two categories, said categories being hierarchically ordered, the category highest in the hierarchy being said high-priority zones and each other category being assigned a different predetermined threshold value, for which the predetermined threshold value of the temperature is the highest for the zone lowest in the hierarchy.

By having different thresholds the importance of cooling of the zones can be differentiated.

In a variant of the method with said high-priority zones comprising at least one local temperature maximum of the surface temperature distribution map.

By having a local temperature maximum in a high-priority zone it is ensured that the cold plate is structured to cool most efficiently in the area of maximum temperature. Furthermore, it is ensured that the high-priority zone is placed in an active area of the computing device.

In a variant of the method further predefines the fixed location of one or more inlet channels.

By fixing one or more inlet channels it can be controlled where the fluid will enter the cold plate. Thus if a symmetry of the heat map makes it straightforward to place an inlet channel close to the temperature maxima on the heat map, this can make the optimisation faster and better. Another aspect could be that the inlet channel can be restricted mechanically and therefore need to be in a fixed position.

In an alternative variant the method comprises predefining the fixed locations of at least two inlet channels

In the following specific examples according to aspects of the present disclosure will be explained in more detail with reference to the accompanying drawings. The present disclosure may, however, be embodied in different forms than depicted below, and should not be construed as limited to any examples set forth herein. Rather, any examples are provided so that the disclosure will be thorough and complete, and will fully convey the scope of the invention to those skilled in the art. Like reference numerals refer to like elements throughout. Like elements will, thus, not be described in detail with respect to the description of each figure.

### BRIEF DESCRIPTION OF THE FIGURES

Fig. 1 illustrates the cold plate assembly assembled.
Fig. 2 illustrates a dual CCD CPU chip.
Fig. 3 illustrates a heat map obtained from the CPU chip shown in figure 2.
Fig. 4A illustrates an optimized flow path design for the CPU chip showed in figure 2.
Fig. 4B illustrates an optimized flow path design for a CPU chip with four CCD's and one IOD.
Fig. 5A illustrates an example of a cold plate with designed microchannels.
Fig. 5B illustrates a close-up of a zoom in on the cold plate in figure 5A.
Fig. 5C illustrates the cold plate from figure 5A viewed from below.
Fig. 6A illustrates a distribution layer placed on top of a cold plate.
Fig. 6B shows the distribution layer from below.
Fig. 7 illustrates a cross section of a cold plate assembly.
Fig. 8 illustrates a cross section of a microchannel with microstructures inside.
Fig. 9 illustrates a cross section of a microchannel with cylinders inside.
Fig. 10 illustrates a microchannel made as a 3D lattice.
Fig. 11 illustrates an arrangement of channels directing a split flow.
Fig. 12 illustrates an arrangement of channels directing a uniting flow.
Fig. 13 illustrates an arrangement of channels directing a straight flow.
Fig. 14 illustrates an alternative arrangement of channels directing a straight flow.
Fig. 15 illustrates a cold plate design comprising a split flow and two uniting flows along with an example heat map for a component to be cooled.

### DETAILED DESCRIPTION OF THE INVENTION

In the following, the invention is described in detail through embodiments thereof that should not be thought of as limiting to the scope of the invention.

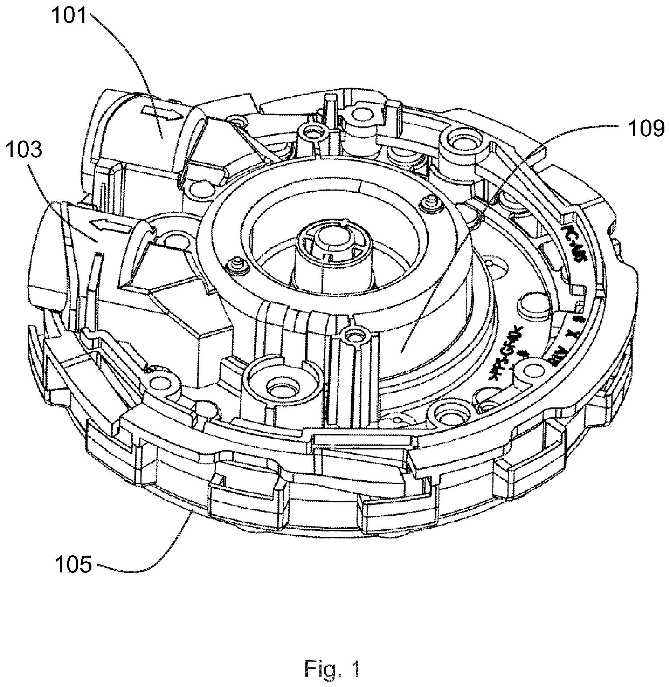

An embodiment of the invention can be seen in Fig. 1. In the illustrated system the cold plate assembly comprises three parts: a cold plate 105, a distribution layer, and a top layer 107. The system has an inlet 101 for the cooling liquid to get into the cold plate assembly and an outlet 103 for guiding the cooling liquid out of the cold plate assembly.

The cold plate 105 is used for heat exchange between the computing device and the cooling liquid. By a cooling liquid is understood any liquid which may be used in a liquid cooling system to transfer heat, e.g. water or a mixture of liquids with suitable properties regarding heat transfer, heat capacity, and thermal expansion such as any coolant known to be suitable for liquid cooling systems. When the cold plate assembly is mounted to cool a computing device, the cold plate 105 is arranged with an external surface in thermal contact with the computing device to be cooled. The top layer 107 is for taking in cooling liquid and directing it into the distribution layer and cold plate 105. The top layer 107 is further adapted for directing cooling liquid away from the cold plate and distribution layer. The top layer may consist of multiple parts. In a preferred embodiment the top layer may have an outlet 103 and an inlet 101.

The distribution layer is used to distribute cooling liquid into the cold plate and to ensure a liquid tight system. In some embodiments the top layer 109 may be foregone and the liquid inlet and liquid outlet arranged directly in the distribution layer.

To drive the cooling liquid trough the cold plate assembly a pump may be used. A pump would circulate cooling liquid in a cooling loop by drawing liquid through an inlet tube into the inlet opening 101 through the cold plate assembly to receive thermal energy from the electronic devices, and out of an outlet 103 to be cooled in another place, typically in a liquid-to-air-radiator or a liquid-to-liquid heat exchanger.

Fastening the cold plate assembly with the exterior surface of the cold plate in thermal contact with a computing device may be done by a conventional bracket fastening from above against the top of the cold plate assembly or by mounting to interfacing holes on a printed circuit board (PCB) of the computing device. Alternatively, the cold plate assembly may have an integrated mounting interface to make it easy to mount it onto a computing device such as a CPU. The cold plate assembly may have further mounting means to facilitate a secure hold such as using screws which may be useful when mounting the cold plate assembly on a processing card, or a graphics card, or such.

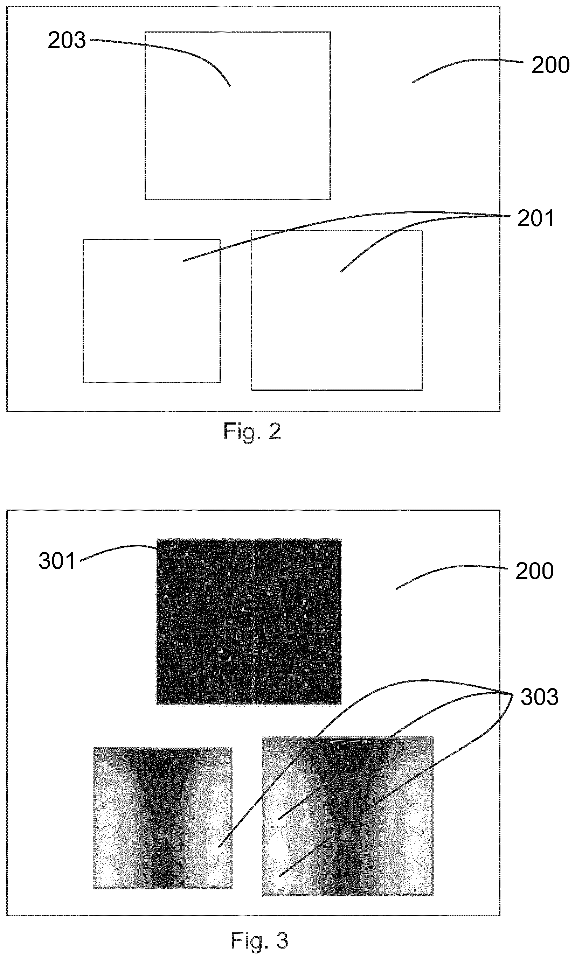

Figure 2 shows an exemplary design of a computing device 200, that comprises of an input/output die (IOD) 203, some core complex dies (CCD's) 201, and may include some connections distributed over the computing device 200. The electrical elements of the computing device use electrical energy to do computational operations and this process produces heat as a bi-product. This heat is produced mostly in some specific areas, i.e. the active regions of the computer device, but the temperature distribution depends strongly on how the cores are placed and may also depend on which tasks the cores run. This invention seeks to design a cooling system for cooling that chip in an efficient manner based on how much heat is produced in different areas on the chip. A computing device can be made in many different shapes and with varying numbers of cores. Therefore Fig. 2 is just one example of a computing device for which a liquid cooling system of the invention can be used for cooling.

In order to identify where the computing device produces heat, the thermal profile of the active computing device may be obtained by mapping out the temperature distribution at different positions corresponding to the computing device. Such a mapping may be represented by a surface temperature distribution map also called a heat map, which is a technique for visualizing data values in 2D. This is typically done by indicating the data value by colors or a gray scale. For this invention a temperature heat map is used. The temperature distribution may be obtained by measurement or simulation or provided by a third party. A measurement may for example be made using an infrared camera to record the electronic device while it is executing a task. In a simulation of the heat production of an electronic device the internal structure of the device may be used to estimate how the heat production will be while the computing device is active. A heat map for a computing device may show an increased temperature in an active region of the device. Active regions of a computing device are the areas where energy used for the computations is converted at least partly into thermal energy.

A heat map for a device like the one shown in Fig. 2 can be seen in Fig. 3. The heat map is only shown for the active components of the chip, the non-active area has no data value and is white. The scale of the heat map shown in Fig. 3 is made such that black represents the lowest temperature and white the highest temperature. If a pixel with white color is inside the IOD 203 or a CCD 201 then it corresponds to a high temperature. If a pixel is white and placed outside the location of the IOD 203 and the CCD's 203 then it illustrates no data. In the example heat map of Fig. 3 it is seen that there are multiple local temperature maxima 303 inside the CCD's 201. The heat map indicates that most of the generated heat is produced by the CCD's 201 compared to the smaller amount of heat produced by the IOD 301. The heat map may be divided into smaller areas each having a maximum and average temperature; these areas may be designated high-intensity or low-intensity zones. Alternatively the areas may be divided based on the maximum and minimum temperature occurring in that area.

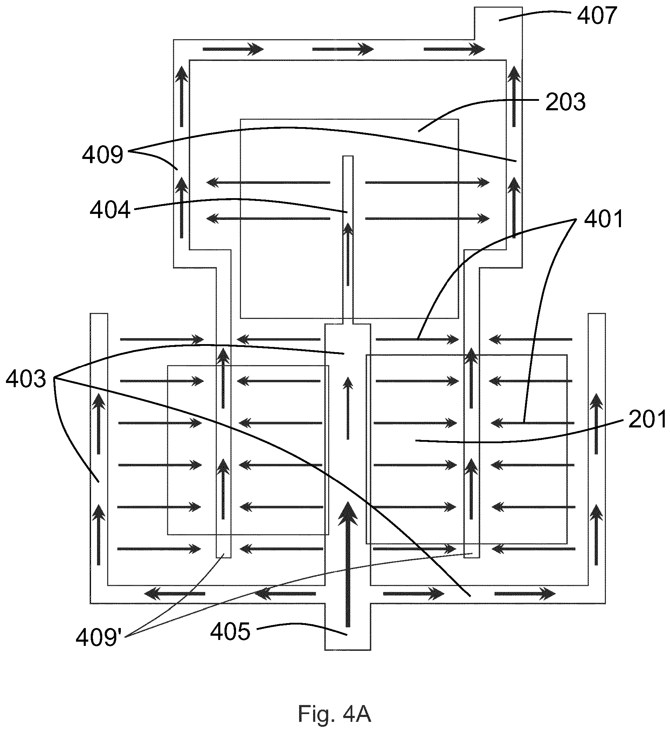

An embodiment of a cold plate assembly according to the invention is illustrated in Fig. 4A. The figure illustrates the liquid flow and heat transfer through the cold plate. The cold plate is placed directly on top of the computing device which needs cooling with direct contact between the exterior surface of the cold plate and the computing device. The cold plate may preferably be made from a material with a high heat conductivity such as copper, aluminum or another metal.

The embodiment illustrated in Fig. 4A is an optimized design for a cold plate assembly for providing effective cooling of a device like the one shown in Fig 2, i.e. for a CPU chip comprising two side-by-side CCDs spaced apart from an IOD. The arrows in the figure illustrate the liquid flow and the width of the arrows correspond to the magnitude of the liquid flow. If the arrow is large the flow rate at that point is higher than the flow rate at segments with a smaller arrow.

In the embodiment illustrated in Fig. 4A liquid enters the distribution layer via the inlet 405 wherefrom the liquid is guided into three inlet channels 403 which are in fluid communication. These three inlet channels 403 form an inlet network the channels of which are in direct fluid communication. Segments of the inlet channels 304 are arranged parallel to each other. The inlet channels 403 are connected to microchannels 401. The inlet channels may have different dimensions in order to control the liquid flow through them. For example a constriction may be made by having a stepwise difference in the cross-sectional area of the channel. In another example the constriction may take the form of a tapering of at least a section of a channel such that the channel is wider at a first position than at a second position. The flow decreases if the size of the channel decreases. The middle inlet channel of the embodiment of Fig. 4A comprises of constricted segment 404 of decreased size; in Fig. 4A this is indicated by the width of the flow arrows. The decrease in size in the constricted segment 404, i.e. the decrease of the cross-sectional are of the inlet channel, reduces the flow rate past this constriction. The reduced flow is in the area of the cold plate that is supposed to be arranged on top of the IOD 301 of the computing device, i.e. the area which needs less cooling than the other heat generating areas of the computing device.

The microchannels 401 may also have different dimensions to guide the flow of cooling liquid, in the figures this is indicated by the width of the arrows illustrating the microchannels 401.

The cold plate assembly comprises liquid channels. The arrangement of these liquid channels may be grouped into different liquid flow types, particularly relevant are split flow, uniting flow, and straight flow.

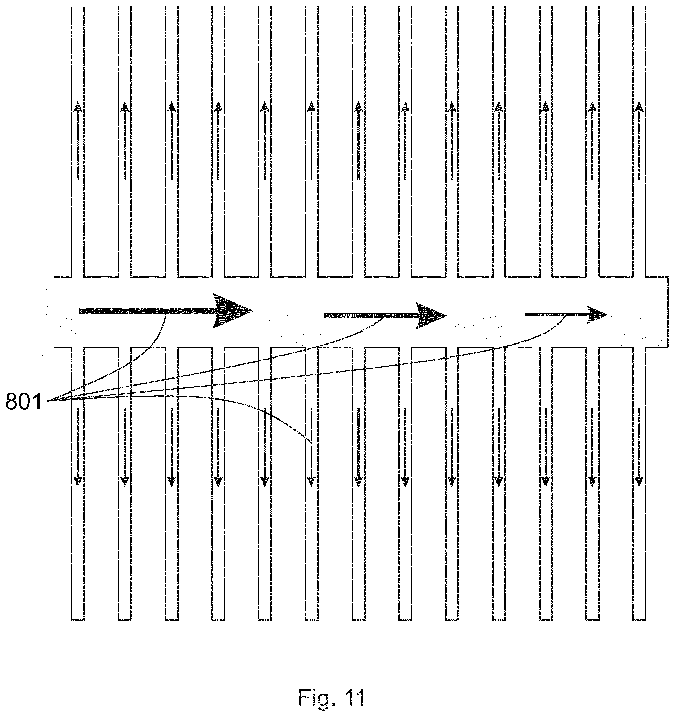

Split flow describes a liquid flow which branches off into multiple channels from an inlet channel, where the channels branching off guide a liquid flow in at least two directions away from the inlet channel. Fig. 11 illustrates a split flow where an inlet channel is in liquid communication with a plurality of microchannels arranged to split the flow of the cooling liquid as it is directed from the inlet channel into the microchannels and the liquid flow 801 is directed to both sides of the inlet channel. In some preferred embodiments the channels directing the flow away from the inlet channel in multiple directions are microchannels. In some preferred embodiments the split flow directs the liquid flow 801 away from the inlet channel in the two opposing directions perpendicular to the inlet channel as illustrated in Fig. 11. The liquid flow may be split from the inlet channel into any number of channels e.g. two, three, four, five, six or more channels. In some embodiments multiple areas of the cold plate assembly comprise split flow.

In a preferred embodiment a zone of a cold plate assembly may be considered to be adapted for liquid flow of the split flow type when it comprises an inlet channel fluidically connected by guiding means to at least two outlet channels located on either side of the inlet channel such that cooling liquid flow is directed in a split flow manner from the inlet channels to the outlet channels.

An example of split flow is illustrated in Fig. 4A and takes place when part of the liquid flow is split from the constricted segment of the inlet channel 404 and directed into multiple microchannels 401. A liquid flow may be split from an inlet channel into multiple microchannels as illustrated in Fig. 11.

In preferred embodiments split flow may guide cooling liquid to the positions that need effective cooling as the cold cooling liquid enters through the inlet channels and is distributed through the microchannels where the cooling liquid is heated. The cooling liquid may be guided into the cold plate assembly through one or more inlets and distributed in the cold plate assembly by one or more split flows.

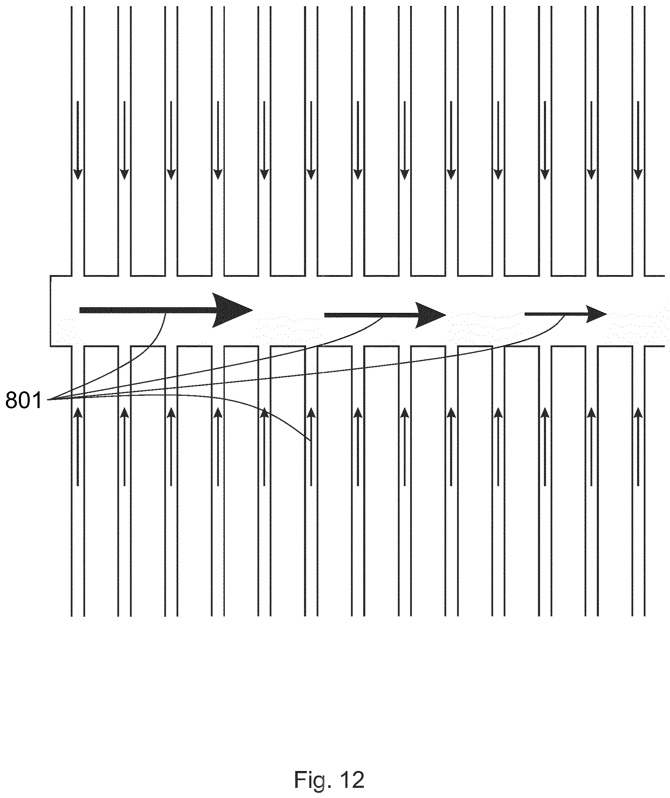

Uniting flow describes a flow type wherein multiple channels guiding flow in different directions are connected such that the flow enters into a single channel. In preferred embodiments flow is united at multiple points along the single channel. In preferred embodiments the single channel may be an outlet channel. Fig. 12 illustrates a flow of the type uniting flow as microchannels from both sides of an outlet channel are connected to the outlet channel. The liquid flow 801 is directed by microchannels into the outlet channel from each side of the outlet channel. There may be any number of channels merging or uniting the flow into the single channel. In some embodiments uniting flow is arranged such that liquid flow is directed from a plurality of microchannels into an outlet channel in a perpendicular fashion from opposite sides of the outlet channel as illustrated in Fig. 12. In some embodiments multiple areas of the cold plate assembly comprise uniting flow.

In a preferred embodiment a zone of a cold plate assembly may be considered to be adapted for liquid flow of the uniting flow type when it comprises an outlet channel fluidically connected by guiding means to at least two inlet channels located on either side of the outlet channel such that cooling liquid flow is directed in a uniting flow manner from the inlet channels to the outlet channel.

An example of uniting flow may be when microchannels 401 are fluidically connected to the same outlet channel 409 from both sides of the outlet channel 409 as illustrated in Fig. 4A. Guiding means may be defined as ending where they fluidically connect to an outlet channel such that outlet flow occurs when multiple microchannels end in the same outlet channel from opposite sides of that outlet channel. Embodiments of cold plate assemblies according to the invention may comprise any number of outlet channels, furthermore the outlet channels may comprise segments of different flow types e.g. having a segment with split flow and another segment with a flow of the type uniting flow. In some embodiments the outlet channels may only be in the cold plate of the assembly. In other embodiments the outlet channels may be located in both the cold plate and the distribution layer. The outlet channels may connect to one or more outlets in the distribution layer. The positioning of the uniting flow in the cold plate assembly may be dependent on where the outlet channels are arranged and the connection points where the microchannels enter the outlet channels. The position of the uniting flow may depend on where the computing device is producing heat. Uniting flow may be the flow type of an area of the cold plate assembly. The area with uniting flow may be different from the area with split flow. In preferred embodiments the cold plate assembly comprises one or more areas with uniting flow and one or more areas with split flow. In some preferred embodiments one or more of the split flow areas are distinct and separate from the uniting flow area.

Uniting flow may merge heated cooling liquid into fewer channels to effectively guide the heated cooling liquid away from the cold plate. As the heat from the computing device is most efficiently transferred to the cooling liquid in the microchannels, the cooling liquid may be hot when exiting a zone with uniting flow.

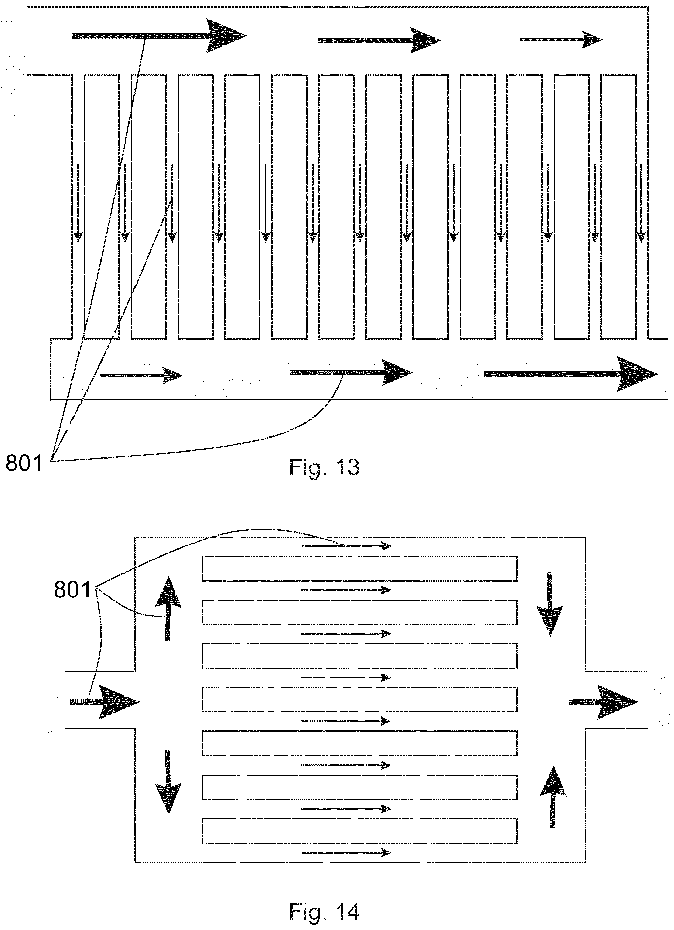

Straight flow describes the situation where liquid flow is directed from a first channel to a second channel through a plurality of channels in the same direction, this may for example be multiple channels split from one channel in the same direction and merge into a second channel. Fig. 13 illustrates an example of straight flow where an inlet channel is connected to an outlet channel by a plurality of microchannels directing the liquid flow from the inlet channel to the outlet channel parallelly in the same direction. The microchannels enter an outlet channel where the liquid flow is merged. This provides a flow in the same direction over an area and is therefore denoted straight flow. Another example of the flow type straight flow is illustrated in Fig. 14, in this case the liquid enters in the middle of the inlet channel such that the flow broadens in opposite directions in the inlet channel and subsequently in the same direction in the microchannels before being combined again to a single flow.

The efficiency of the cooling of a computing device may depend on how the channels are distributed and connected and thus which flow types are used in the cold plate assembly and where these types of flow are positioned.

In an embodiment at least part of the inlet channels are positioned over a high-intensity zone of the computing device, and the microchannels exiting from the inlet channel exit from the edge of the inlet channel that overlaps with the high-intensity zone. This may be obtained by having a split flow at least partly overlapping with a high-intensity zone.

In an embodiment an inlet channel and a connected outlet channel are positioned on opposite sides of a high-intensity area of the computing device which the cold plate assembly is designed to cool. The inlet and outlet channel may be positioned such that it is placed on each side of a temperature maximum in the high-intensity area. The inlet channel may overlap with the high-intensity zone. The outlet channel may overlap with the high-intensity zone. The inlet channel may overlap with a temperature maximum of the computing device. Alternatively the inlet channel may be positioned adjacent to a temperature maximum of the computing device.

The microchannels of the cold plate may all have the same size. The microchannels of the cold plate may have two or more different sizes to provide varying flow in different areas, e.g. a higher flow of cooling liquid in one area and a lower flow of cooling liquid in another area.

The openings of the distribution layer, e.g. inlets and outlets, may be optimized to cool the computing device. Optimizing the cooling may be performed in different ways. The openings may be positioned close to high intensity areas of the computing device. More specifically the openings of the distribution layer may be positioned near one or more temperature maxima of the computing device. The openings of the distribution layer may be denoted inlets and/or outlets. The distribution layer may have one or more inlets and one or more outlets.

The cold plate assembly may comprise a uniting flow by comprising an outlet channel to which cooling liquid may enter from microchannels from two sides. This may be normal to the side of the outlet channel such that the liquid flow changes direction of 90° when going from the microchannels into the outlet channel. As the liquid may enter the outlet channel from two sides the outlet channel may be positioned between two inlet channels. The outlet channel may be placed in the midway between the two inlet channels, i.e. such that there is equal spacing between the outlet channel and each of the adjacent inlet channels or anywhere in between the two inlet channels such that the microchannels are shorter from one inlet channel to the outlet channel than from the other inlet channel to the outlet channel. The outlet channel may be arranged anywhere in the cold plate assembly. The outlet channel may be at least partly overlapping with the active region of the computer chip. The outlet may at least partly overlap with a high intensity zone. The outlet may be arranged in between two high intensity zones. The outlet may be arranged in a low-intensity zone. The outlet may be arranged in between two local temperature maxima of the computer chip. As illustrated in Fig. 4A the end point 409' of each of the two outlet channels 409 is positioned in between the three inlet channels 403. One or more of the inlet channels may be positioned anywhere in the cold plate assembly. This may be outside the area of the cold plate assembly that is for cooling of the computing device or inside the area of the cold plate for cooling the computing device. One or more of the inlet channels may be positioned to partly overlap with the active regions of the computing device. One or more of the inlet channels may be positioned to partly overlap with high intensity zones of the computing device. One or more of the inlet channels may be positioned to partly overlap with temperature maxima points/area of the computing device. To place an outlet channel in between two inlet channels may provide an optimized cooling of a computing device. One reason for the improved cooling may be that the active components of a computing device such as a CCD, IOD, or similar often produces the most heat at the edges of the component. Therefore it may be advantageous to place the microchannels over these heat-producing areas with the inlets close to or overlapping with the heat producing area.

To provide the most effective cooling the flow types of the cold plate may be positioned according to the areas that produce heat and the areas that does not produce heat.

The computing device may have a first and a second active region which generate heat. The two active regions may be separate from each other. The first active region may be cooled by a first flow type being any of the flow types split flow, uniting flow, or straight flow and the second active region may be cooled by a second flow type being any of the flow types split flow, uniting slow, or straight flow. The first and the second flow type are different flow types e.g. the first flow type is split flow and the second flow type is uniting flow or straight flow. According to an example not part of claimed subject-matter, the first and the second flow types may be the same flow type e.g. both split flow or both uniting flow. By having a first flow type in a first active region and second flow type in a second active region the computing device may be cooled in two different ways or two similar ways. This may provide the optimal cooling for a computing device with either similar or different active regions and active components. If split flow is one of the two flow types the split flow may be positioned either at the edge of the active region or at the center of the active region. If one of the flow types of the two flows are uniting flow the uniting flow may be positioned at the center of an active region.

The cold plate assembly of the embodiment illustrated in Fig. 4A further comprises two outlet channels 409. The outlet channels 409 are arranged such that when the cold plate assembly is mounted on the target computing device, the outlet channels will be arranged in contact with regions of low thermal energy. One or more segments of each outlet channel 409 is arranged parallel to one or more segments of at least one inlet channel.

The microchannels 401 are connected to the outlet channels 409 and the inlet channels 403 such that liquid can flow from the inlet channels 403 through the microchannels 401 into the outlet channels 409. The outlet channels 409 are connected to at least one outlet 407. The liquid flows out the outlet 407 from where it is directed away to be cooled outside the cold plate assembly before it is pumped back into the inlet 405 again.

The spacing between the microchannels may in some embodiments be made different at different regions of the cold plate, e.g. it may be different in a region which is to be mounted on top of the IOD 203 or the CCDs 201 of the target or in areas where there are no active regions.

In the embodiment illustrated in Fig. 4A the channels are formed in a combination of the cold plate and the distribution layer. In some embodiments all microchannels are formed in the cold plate while inlet and outlet channels are formed in the distribution layer. In other embodiments all microchannels are formed in the cold plate while at least parts of the inlet and outlet channels are formed in the distribution layer and parts of the inlet and outlet channels are formed in the cold plate. In all embodiments there will be microchannels in the cold plate. Furthermore, the in- and outlet channels will go through the distribution layer.

In a preferred embodiment the cold plate assembly comprises two or more different flow zones having at least two different types of flow, i.e. a first flow zone being of the split flow type and a second flow zone being of a uniting flow type.

In a preferred embodiment the cold plate assembly comprises one or more outlet channels which can be divided into branches such that each branch is arranged to direct continuous flow of cooling liquid in the same flow direction. In a preferred variant of such an embodiment at least one branch of an outlet may be divided into two or more outlet segments along the flow direction of the branch of the outlet channel such that at least two segments are configured to receive cooling liquid of two different flow types, e.g. a first segment of a branch of an outlet channel is configured to receive cooling liquid in a split flow configuration while a second segment of the same branch of the outlet channel is configured to receive cooling liquid on a uniting flow configuration. An example of this is illustrated in Fig. 4A where the rightmost branch of the outlet 409 initially has a segment of the uniting flow configuration near the end point 409' while later in the flow direction, i.e. closer to the outlet 407, the outlet channel 409 has a segment receiving liquid from a split flow placed on top of the area 203. The zones having the two different flows may not overlap in such a way that the outlet channel of a split flow is also receiving cooling liquid in the same zone or at the same position along the outlet channel in the opposite direction, i.e. an outlet channel cannot be supporting both split flow and uniting flow simultaneously. Thereby the two zones with the two flow types may be two separate zones.

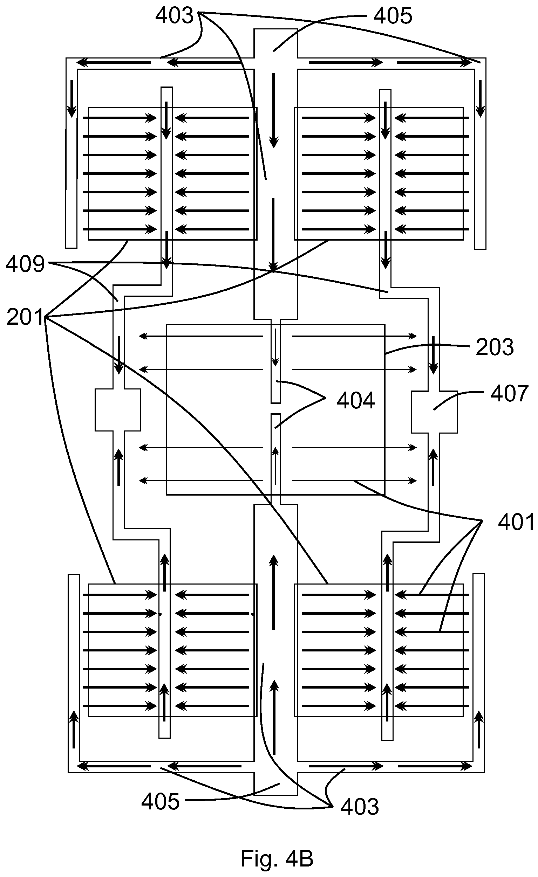

Another embodiment of the invention is shown in Fig. 4B. The illustrated embodiment is a design of a cooling system for a computing device with four CCDs 201 and one IOD 203. The IOD 203 is drawn as a rectangle in the middle of the figure and the CCDs 201 are also drawn as rectangles arranged adjacent to each other on opposing sides of the IOD 203 thus forming a structure which is mirror symmetric along two perpendicular axes centered on the IOD. The channels drawn illustrate the channels formed by the cold plate and distribution layer. The arrows illustrate liquid flow which is only present inside channels. The liquid flow in the microchannels 401 is illustrated by the arrows 401.

In the embodiment shown in Fig. 4B the liquid enters through two inlets 405. From the inlets the liquid is distributed into six inlet channels 403. The liquid can flow from the inlet channels 403 into the microchannels 401. The microchannels extend between an inlet channel 403 and an outlet channel 409 of the cooling system. From the outlet channels 409 the liquid can flow until it reaches one of the two outlets 407. In this embodiment part of at least some of the inlet channels 404 have an end which is smaller than the first end of the inlet channel, the first end of an inlet channel being the end of the inlet channel where liquid flow enters, i.e. the end connected to an inlet 405. As the area of the cross section of a channel gets smaller the flow decreases.

In general the invention can have many different embodiments with different shapes and features. Common for the embodiments is that they may comprise one or more inlets for the cold plate assembly and one or more outlets. Furthermore, the cold plate assembly may comprise one or more inlet channels and one or more outlet channels additional to a multiple of microchannels. The one or more inlet channels may be in direct fluid connection/communication to one or more of the inlets. By direct fluid connection is understood fluid communication between two channels which is not mediated trough another set of pipes or channels. If two components are in direct fluid connection it is to understood as the two components are directly connected. The inlet channels may be in direct fluid contact with the microchannels. The microchannels may be in direct fluid contact with the outlet channels. In such a configuration the inlet channel and the outlet channel may be in indirect fluid communication mediated via the microchannels. The outlet channel may be in direct fluid contact with the outlet. The outlet, inlet, outlet channels, inlet channels, and microchannels may be formed by the cold plate, the distribution layer, the top layer, be formed in only one of these layers, or a combination of these three layers. The inlet channels may comprise a constriction such that the area of the cross section of the inlet channel decreases, e.g. by a stepwise change of by tapering.

Part of the invention is a method for designing a cold plate assembly that cools a specific computing device effectively and with differentiated cooling. By differentiated cooling is understood when the system is designed to transport more heat away from some parts of the cold plate than other parts. There are a lot of important parameters when producing a design for a specific cold plate some of these are: pressure of the liquid, dimensions of the microchannels, number of the microchannels, shape of the microchannels, temperature of the cooling liquid, flow of the cooling liquid, flow resistance in the system, number and placement of in and outlet slots.

In order to design a cold plate assembly with optimized cooling the heat map is split into smaller areas based on the heat generation in the areas and these areas are called intensity zones as described earlier. After this each intensity zone is categorised in at least two categories, namely high-priority zones or a low-priority zones. High-priority zones are defined as zones where the optimisation target is that the maximum temperature is minimized to be as low as possible. The criteria for high-priority zones may alternatively be that an average temperature for that zone is minimized to be as low as possible.

Low-priority zones are defined such that the optimisation target is that the maximum temperature in that zone is kept under a defined threshold temperature. For low-priority zones the criteria could also be that the average temperature should be lower than a threshold value.

If it is desired, all the intensity zones may be categorised as high-priority zones, such that there is no low-priority zones. If the heat map can be described by a single function that would make it possible to minimise the global temperature maximum across all of the heat map as if it was one high-priority zone. This might be more difficult if the heat map is described by multiple functions and/or by division in discrete areas. The heat map may be divided into multiple intensity zones to provide more control of the optimisation in particular for situations where the heat map is described by more than a single function.

In some embodiments high-priority zones may coincide completely or partially with the high-intensity zones of the heat map. In other embodiments one or more high-priority zone may be located elsewhere with respect to the target computing device, e.g. over an active region having special cooling needs even though it itself does not generate as much heat as other active regions of the computing device.

Additional categories of intermediate-priority zones or subdivisions of the low-priority zones may have the condition that the temperature needs to be kept within a range, e.g. 20-50 °C. By introducing multiple threshold temperature values for the low-priority zones, these can be split into multiple low-priority categories. The categories may be ordered hierarchically such that the high-priority zone is highest in the hierarchy. The low-priority zone with the highest threshold temperature is lowest in the hierarchy and the low-priority zone with the lowest threshold value is higher in the hierarchy than the other low-priority zones but lower in the hierarchy than the high-priority zones. An example of such hierarchy having three zones: a low-priority zone with a threshold value of 40 °C, a high-priority zone, and a low-priority zone with a threshold value of 60 °C. The hierarchy for the optimization of these three zones would be with the highest priority first: the high-priority zone wherein the optimization target is to minimize the temperature, the low-priority zone with a threshold value of 40 °C, and the low-priority zone with a threshold value of 60 °C.

A method, not part of claimed subject-matter, of designing a cold plate assembly comprises the following steps:
- Obtain a heat map of the computing device which is to be cooled, i.e. a mapping of the heat flux of the computing device.
- Divide the heat map into smaller areas and categorize these areas as high- or low-intensity zones depending on how much heat is produced in that area.
- Categorize all intensity zones such that each zone belongs to one of the categories; high-priority zones, low-priority zones based on the desired cooling of the computing device. In this process at least one intensity zone should be allocated as a high-intensity zone.
- Define the position of the inlet and outlet for the cold plate assembly.
- Place inlet channels, outlet channels and microchannels. This may be done by an initial guess or by full optimization using a computer program.
- Do iterative optimization of the positions, numbers and sizes of the inlet channels, microchannels, and outlet channels. In each step the heat flux is calculated and the system is optimized to minimize the temperature in at least one high-priority zone.

In preferred variants this method will result in the inlet channel being positioned such that it is partially coinciding with a high-intensity zone. Meaning that the projection of the inlet channel onto the computing device will overlap at least some of the area of a high-intensity zone.

In methods for obtaining cold plate assemblies optimized for specific computing devices different parameters may be specified for the specific cold plate assembly such that it provides an optimal cooling for the specific computing device. As partly stated earlier, parameters of an optimized cold plate assembly may be at least the number of flow types, flow type position, flow type combinations, number of inlets, inlet positions, inlet sizes, number of outlets, outlet positions, outlet sizes, number of inlet channels, position of inlet channels, height and width of inlet channels, number of outlet channels, position of outlet channels, height and width of outlet channels, constrictions in inlet channels and outlet channels, number of microchannels, position of microchannels, width and height of microchannels, thickness of the walls between the microchannels.

The flow types needed for a specific cold plate assembly for cooling a specific computing device may be the first parameter determined in designing a cold plate assembly by optimization. The flow types may be determined based on the heat map of a specific computing device. The flow types may be determined to be straight flow and/or split flow and/or uniting flow. Different areas of a computing device may be cooled best by a specific type of flow. For example high-intensity areas tend to be heated a lot and therefore having a split flow with cold cooling liquid in this area may be optimal. This is just one example, there may be many different positions where a split flow could be the optimal flow to use. A split flow may be positioned close to a high-intensity area or in between two high-intensity areas.

Additionally, to determine which flow types should be used and where they should be positioned in the cold plate assembly other parameters describing how the distribution layer is formed may be determined. These parameters may be the number of inlets, the number of outlets, the position of the inlets, the position of the outlets, the shape of the inlets, the shape of the outlets, the shape of the distribution layer, and position and shape of channels in the distribution layer. These parameters may be determined based on a heat map of the specific computing device.

The parameters may be determined based on a heat map in the prioritized order:
1. Flow type.
2. Position, size, number and shape of inlets and outlets in the distribution layer.
3. Size, position, shape and number of channels in the cold plate assembly such e.g. inlet channels, outlet channels, and microchannels.

Each of these parameters may be determined by starting with an initial guess and optimizing that, or start without any guesses of parameters and have a computer program optimizing all the parameters using algorithms, or parameters may be determined manually. The parameters determined manually may be used to ensure that the cold plate assembly may be manufactured or has a specific desired feature.

In a method for obtaining a cold plate assembly the method may comprise the following steps or only some of the following steps:
- 602 obtain a heat map of the computing device which is to be cooled, i.e. a mapping of the heat flux of the computing device.
- 604 based on the heat map determine the type of flows to be used in the cold plate assembly.
- 606 based on the heat map determine where in the cold plate assembly at least one split flow should be positioned and where at least one uniting flow is positioned to provide optimal cooling of the computing device.
- 608 based on the heat map determine the position of all the types of flow for use in the cold plate assembly.
- 610 based on the heat map determine the number, size, shape and position of the inlets and outlets of the distribution layer such that these parameters fit the specific flow types obtained in all previous steps.
- 612 based on the heat map determine the size, position, shape, and number of channels in the cold plate such that these parameters fit the specific flow types obtained in previous steps.

Any of the steps may be done by an initial guess or by full optimization using a computer, this may be using algorithms run on a computing device.

The following steps may be part of the method:
- 614 divide the heat map into smaller areas and categorize these areas as high- or low-intensity zones depending on how much heat is produced in that area.
- 616 categorize all intensity zones such that each zone belongs to one of the categories; high-priority zones or low-priority zones based on the desired cooling of the computing device. In this process at least one intensity zone should be allocated as a high-intensity zone.
- 618 define the position of the inlet and outlet for the cold plate assembly.
- 620 do iterative optimization of the flow types, the positions, numbers and sizes of the inlet channels, microchannels, and outlet channels. In each step the heat flux is calculated and the system is optimized to minimize the temperature in at least one high-priority zone.

All of the steps may be optional and the order they are performed in does not need to be as listed here, thus the steps may be executed in any order.

The order of the steps in the method 600 may be as listed here and the steps may need to be performed in the consecutive order.

When determining a position of an element like a channel this may be done by optimization using a computer. This optimization may be minimizing the maximum temperature, the average temperature within a given area. There may be different criteria for different areas.

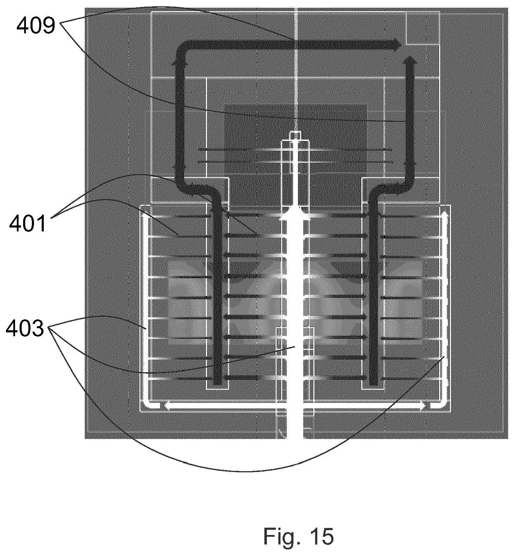

An example of a cold plate obtained by the method 600 is illustrated in Fig. 15. The resulting design comprises a split flow and two uniting flows. The microchannels 401 merge in uniting flows into outlet channels. One or more of the inlet channels may be positioned partly overlapping with a high-intensity zone. One or more of the outlet channels may be positioned between two high-intensity zones. The illustrated design provides the most optimal cooling for this specific heat map, the heat map is the grey scale maps in the three rectangles.

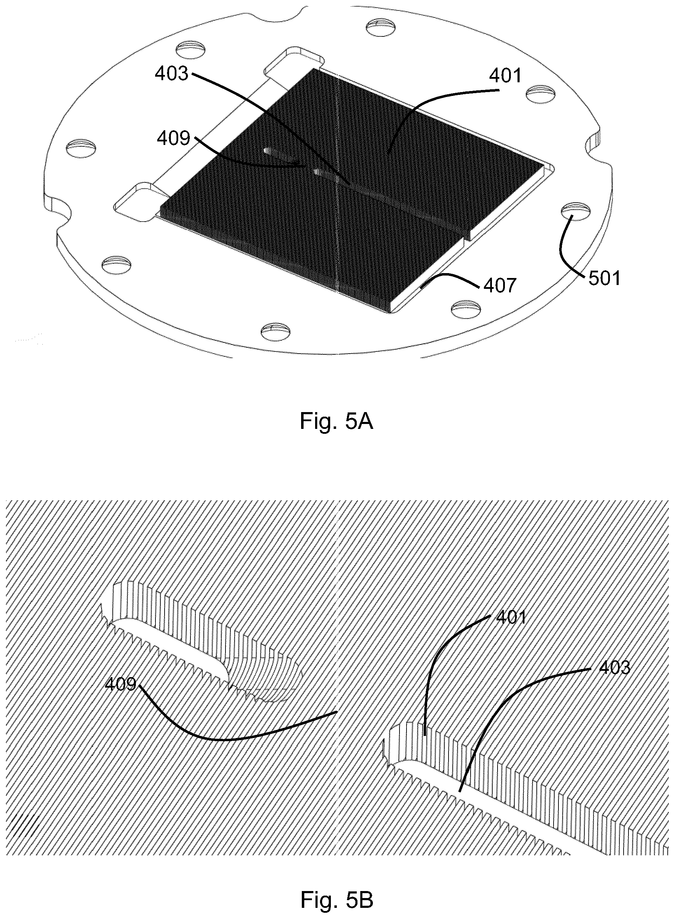

The cold plate for an embodiment illustrated in Fig. 4A can be seen in Fig. 5A. The cold plate has an exterior surface for facing a computing device. The cold plate has an inner surface adapted to be in contact with a cooling liquid. The cold plate assembly further has a distribution layer. The cold plate has mounting holes 501 for fastening means such that the top layer of the system can be held together with the distribution layer onto the cold plate and such that the system becomes liquid tight. In other embodiments the cold plate assembly may be held together by other fastening means like clamps or glue. The inlet channels are partly formed by the features 405 and 407 in combination with the distribution layer. While grooves in the cold plate extend all the way around the microchannels 401, the inlet channels 407 of the cooling system embodiment of Fig. 4A are blocked by part of the distribution layer such that the inlet channels becomes confined to part of the microchannels as illustrated in Fig. 4A. The middle inlet channel 405 decreases in size at the contraction 409 as the cross-sectional area of the inlet channel in the distribution layer is decreased in the area above the contraction 409.

In Fig. 5B a zoom in on the middle of the cold plate shown in Fig. 5A can be seen. The middle inlet channel 405 is visible and the microchannels 401 can be seen. The shape of the constriction 409 in the inlet channel 405 is seen to be an area of microchannels extending across the region of the inlet channel, the inlet channel of the embodiment is however not blocked as it extends in the distribution layer above the cold plate. The inlet channel expand again after the constriction 409. The constriction 409 leads to an increase in the flow resistance for the liquid at the position of the constriction 409. This reduces the pressure in the channel after the constriction 409. As the inlet channel increase in size again the pressure will not decrease appreciably from right after the constriction and until the liquid enters the microchannels. Generally the flow resistance is highest when the size of the channel is smallest. Thus the pressure decrease as the size of a channel decrease. The pressure also decreases as the channel gets longer. From this it is evident that the largest flow resistance and pressure loss is due to the microchannels in the cold plate assembly.

In order to be able to cool more in some places than others on the cold plate it is important to be able to control the flow rate of the liquid and to be able to differentiate this. Furthermore it is important that the liquid can exchange heat with the cold plate. The heat exchange between the cold plate and the liquid depends on the surface area of contact between them. The choice of cooling liquid and material for the cold plate are also relevant factors for controlling the heat exchange. Another important parameter is the pressure of the liquid at the inlet and the outlet. The pressure may be controlled by a pump, thus the maximum pressure in the cooling system is limited by the choice of pump.

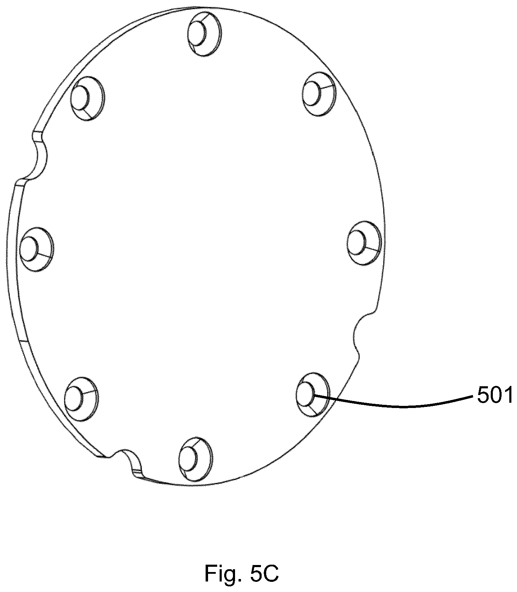

In Fig. 5C the cold plate is seen from below, i.e. showing the exterior surface of the cold plate. This surface is the surface which is to be arranged in contact with the computing device for cooling. The cold plate has holes 501 for fastening the different parts of the assembly to hold them together.

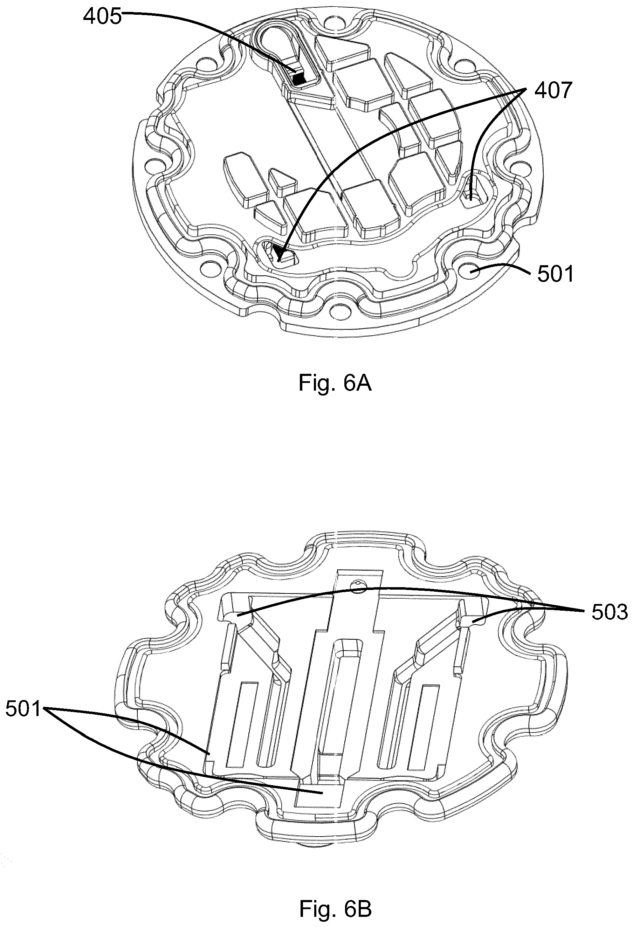

The distribution layer placed on top of the cold plate can be seen in Fig. 6A. The inlet 405 is shown and the outlet 407 can also be seen. The top layer of the assembly is not shown in Fig. 6A but will in the mounted cooling assembly be used to hold the distribution layer by fastening means that can be fastened through the mounting holes 501.

The distribution layer forms part of the inlet channels 405 and outlet channels 409. This can be seen in Fig. 6B where the distribution layer is seen from below, i.e. showing the side which contacts the cold plate when the cold plate assembly is assembled, such that the channels for distributing cooling liquid can be seen. The distribution layer may be made of a deformable material such as rubber. A deformable material is beneficial to making the cold plate assembly liquid tight, thus the distribution layer 107 also functions as a sealing layer.

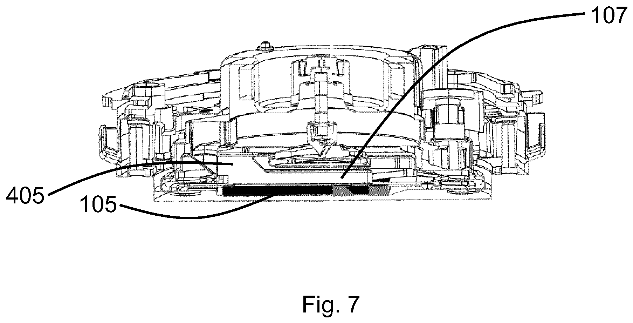

A cross section of one embodiment of the cold plate assembly is shown in Fig. 7. Here some of the channels can be seen e.g. the inlet channel 405 which is partly formed in the distribution layer 107 and the cold plate 105. The top layer, distribution layer 107, and the cold plate are held together by fastening means e.g. using mounting holes 501.

As an important aspect of this invention is to transfer heat from the cold plate to the liquid flowing through the cold plate assembly, the arrangement of the microchannels is significant for the resulting cooling. The microchannels can be made in different manners and having different shapes. One way of producing microchannels is to make fins by mechanical cleaving thus forming microchannels in between the fins. The embodiment of Fig. 5A may be produced by such cleaving.

Another method to manufacture microchannels is to 3D print them. It is possible to produce microchannels in almost any shapes as 3D printing is a very versatile method. By 3D printing a cold plate it is possible to make microchannels in multiple layers on top of each other. The channels can furthermore be fabricated with bends. A channel produced by 3D printing could start in the top layer and change to a new layer closer to the exterior surface of the cold plate if desired. This could help improving the heat exchange between the liquid and the cold plate without losing too much pressure.

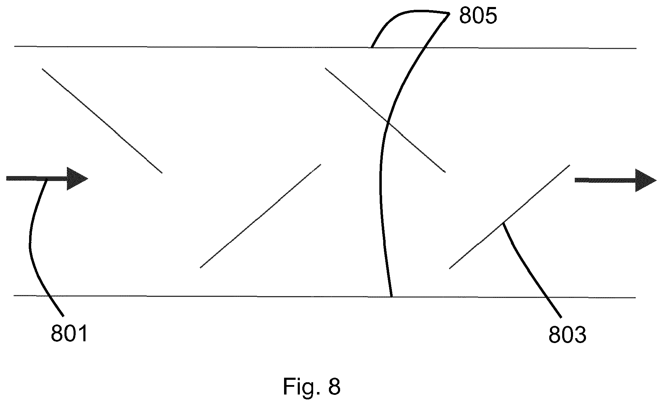

Possible arrangements of microstructures for embodiments of cold plates with 3D printed microchannels are illustrated in figures 8, 9, and 10.

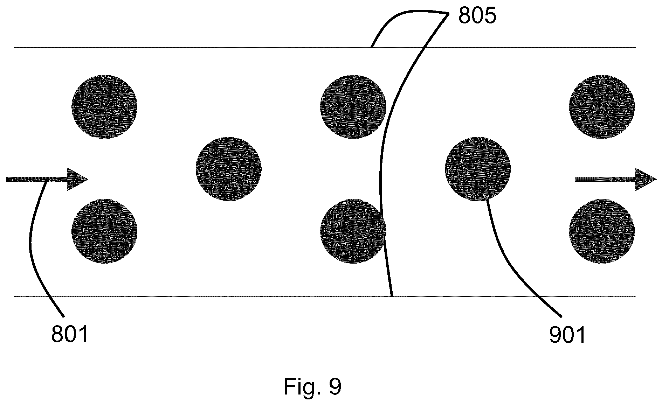

In Fig. 8 a cross section along the direction of liquid flow of a 3D printed microchannel is illustrated. The microchannel has walls 805 to define the microchannel. A flow of liquid is illustrated by the arrows 801. This microchannel has protrusions 803 in a shape of fins extending into the microchannel. The fins may be starting from the bottom of the microchannel and ending at the top or they may extend only part of the way. Protruding microstructures may be shaped in other ways e.g. like cylinders as illustrated in Fig. 9 or as irregular shapes. Different shapes can be made to optimize the heat transfer.

The microchannel illustrated in Fig. 9 has walls 805, a liquid flow 801, and cylinder 901 as microstructure protrusions.

Only one microchannel is shown in the figures 8 and 9, but this may be the form that all or some microchannels in the cold plate assembly have. Similarly different types of microstructures may be found across various microchannels of the same cold plate assembly. Using 3D printing the microchannels could also be fabricated such that they were completely incorporated in the cold plate. That could help keeping the system liquid tight.

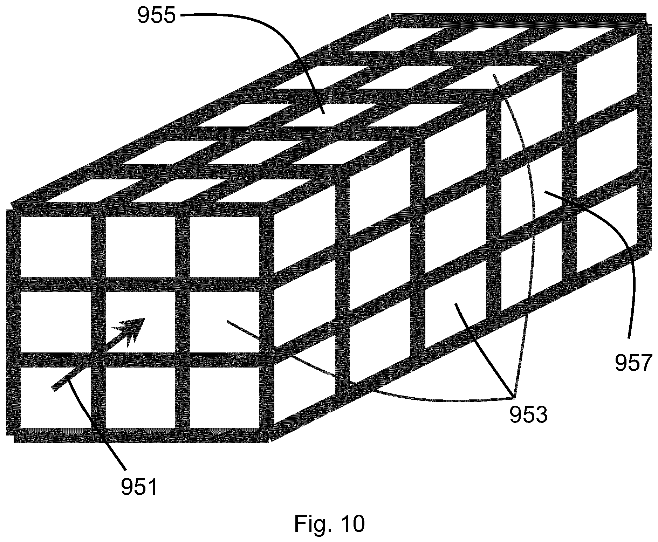

Another embodiment of a channel of this invention having 3D-printed microstructures is illustrated in Fig. 10. The flow path is along the arrow 951. The illustrated 3D structure can be made by placing beams of material in a 3D lattice. The side where the liquid enters the channel illustrated by the arrow 951 is called the first end. The two other sides visible in Fig. 10 are called the top 955 and the first side 957. The microchannel having a rectangular cross section in the direction across the flow further has a bottom and a second side (not visible in Fig. 10) The white rectangles 953 illustrate channels that extend all the way through the microchannel. Because of these channels extending trough the microchannel from all three sides the microchannel start at the first end by being divided into 9 channels, but all of these channels are connected to each other inside the microchannel. In order to direct a liquid flow through the microchannel the top 955, the bottom, the first 957 and second side may be covered by solid material such that no liquid can flow in or out of these four surfaces. This is an illustration of one microchannel, some or all of the microchannels in the cold plate assembly may be shaped like this.

Below is a list of reference signs used in the detailed description of the present disclosure and in the drawings referred to in the detailed description of the present disclosure.
101 Inlet for cooling liquid
103 Outlet for cooling liquid
105 Cold plate with guiding means
109 Top layer
200 Computing device
201 Core complex dies (CCD's)
203 I/O die (IOD)
301 Heat map of IOD
303 Position of heat maxima for the chip design in figure 2
401 Microchannels
403 Inlet channel
404 Constricted segment of inlet channel
405 Inlet
407 Outlet for cooling liquid
409 Outlet channel
409' End point of outlet channel
501 Hole for fastening the parts together
600 Method for obtaining a cold plate assembly
602 Obtain a heat map
604 Obtain the type of flows
606 Obtain a position of at least one split flow and one uniting flow of the cold plate assembly
608 Obtain the positions of all the types of flow in the cold plate assembly
610 Obtain the number, size, shape and position of the inlets and outlets of the distribution layer
612 Obtain the size, position, shape, and number of channels in the cold plate
614 Divide the heat map into smaller areas and categorize these areas as high- or low-intensity zones
616 Categorize all intensity zones such that each zone belongs to one of the categories; high-priority zones or low-priority zones
618 Define the position of the inlet and outlet for the cold plate assembly.
620 Do iterative optimization of the flow types, the positions, numbers and sizes of the inlet channels, microchannels, and outlet channels
801 Arrow indicating the liquid flow
803 Protruding microstructure in a microchannel
805 Walls of a microchannel
901 Microstructure protrusions formed as cylinders
951 Arrow indicating the liquid flow direction
953 Channels that extend through the microchannel structure
955 Top side of a microchannel
957 First side of a microchannel

## Claims

1. A cold plate assembly for use in a liquid cooling system for cooling of a computing device having a plurality of active regions from which heat is dispersed with varying intensity, said cold plate assembly comprising:
a cold plate (105) for exchanging heat between said computing device and cooling liquid of said liquid cooling system, said cold plate comprising an exterior surface for facing the computing device and an opposite inner surface adapted to be in contact with said cooling liquid, said inner surface further comprising guiding means for guiding said cooling liquid along said inner surface in a predefined pattern focusing the liquid flow across one or more zones;
a distribution layer configured to be mounted onto said inner surface of said cold plate, said distribution layer comprising a
- liquid inlet (405) through which said inner surface of said cold plate receives cooling liquid from said liquid cooling system, and a
- liquid outlet (407) through which cooling liquid is discharged away from said inner surface into said liquid cooling system,
said liquid inlet being in liquid communication with an inlet channel (403), said inlet channel and said liquid outlet being in liquid communication with an outlet channel (409), such that at least a first zone of the cold plate assembly is adapted for a liquid flow with one of the flow types
- split flow which branches off into multiple channels from an inlet channel, where the channels branching off guide liquid flow in at least two different directions away from the inlet channel,
- uniting flow wherein multiple channels guiding flow in different directions are connected such that the flow enters into a single channel, or
- straight flow wherein liquid flow is directed from a first channel to a second channel through a plurality of parallel channels
and a second zone of the cold plate is adapted for a liquid flow type of one of the types
- split flow which branches off into multiple channels from an inlet channel, where the channels branching off guide liquid flow in at least two different directions away from the inlet channel,
- uniting flow wherein multiple channels guiding flow in different directions are connected such that the flow enters into a single channel, or
- straight flow wherein liquid flow is directed from a first channel to a second channel through a plurality of parallel channels
and the flow type of the second zone being different from the flow type of the first zone.

2. A cold plate assembly according to claim 1, wherein the first zone of the cold plate assembly has a liquid flow of the type split flow and the second zone has a liquid flow of the type uniting flow.

3. A cold plate assembly according to any of the preceding claims, wherein the first zone overlaps with a first active area of the computing device and the second zone overlaps with a second active area of the computing device.

4. A cold plate assembly according to any of the preceding claims, wherein the first and second active area are separated from each other.

5. A cold plate assembly according to any of the preceding claims, wherein the first zone and the second zone do not overlap in such a way that the outlet channel of the uniting flow is receiving liquid from the split flow.

6. A cold plate assembly according to any of the preceding claims comprising a plurality of inlet channels connected in an inlet network and/or a plurality of outlet channels connected in an outlet network.

7. A cold plate assembly according to claim 6, said inlet network and said outlet network being connected via microchannels (401).

8. A cold plate assembly according to any of the preceding claims, wherein an inlet channel and an outlet channel are arranged on opposite sides of a local temperature maxima of an active region.

9. A cold plate assembly according to any of the preceding claims, wherein at least one inlet channel comprises a constriction such that the cross-sectional area of said inlet channel is larger at a first position than at a second position by tapering and/or a stepwise decrease of said cross-sectional area.

## Patentansprüche

1. Kühlplattenanordnung zur Verwendung in einem Flüssigkeitskühlsystem zum Kühlen einer Rechenvorrichtung, die eine Vielzahl von aktiven Bereichen aufweist, von der Wärme mit variierender Intensität zerstreut wird, wobei die Kühlplattenanordnung Folgendes umfasst:
eine Kühlplatte (105) zum Austauschen von Wärme zwischen der Rechenvorrichtung und der Kühlflüssigkeit des Flüssigkeitskühlsystems, wobei die Kühlplatte eine der Rechenvorrichtung zugewandte Außenfläche und eine gegenüberliegende Innenfläche umfasst, die ausgelegt ist, um mit der Kühlflüssigkeit in Kontakt zu sein, wobei die Innenfläche ferner eine Führungseinrichtung zum Führen der Kühlflüssigkeit entlang der Innenfläche in einem vordefinierten Muster umfasst, das die Flüssigkeitsströmung über eine oder mehrere Zonen richtet;
eine Verteilungsschicht, die konfiguriert ist, um auf der Innenfläche der Kühlplatte montiert zu sein, wobei die Verteilungsschicht
- einen Flüssigkeitseinlass (405), durch den die Innenfläche der Kühlplatte Kühlflüssigkeit aus dem Flüssigkeitskühlsystem aufnimmt, und
- einen Flüssigkeitsauslass (407), durch den Kühlflüssigkeit von der Innenfläche weg in das Flüssigkeitskühlsystem abgeleitet wird, umfasst,
wobei der Flüssigkeitseinlass in Flüssigkeitsverbindung mit einem Einlasskanal (403) steht, wobei der Einlasskanal und der Flüssigkeitsauslass in Flüssigkeitsverbindung mit einem Auslasskanal (409) stehen,
sodass mindestens eine erste Zone der Kühlplattenanordnung für eine Flüssigkeitsströmung mit einer der Strömungsarten
- geteilte Strömung, die sich von einem Einlasskanal in mehrere Kanäle verzweigt, wobei die abzweigenden Kanäle die Flüssigkeitsströmung in mindestens zwei unterschiedlichen Richtungen von dem Einlasskanal wegführen,
- vereinigende Strömung, wobei mehrere Kanäle, welche die Strömung in unterschiedlichen Richtungen führen, derart miteinander verbunden sind, dass die Strömung in einen einzelnen Kanal eintritt, oder
- geradlinige Strömung, wobei die Flüssigkeitsströmung von einem ersten Kanal durch eine Vielzahl paralleler Kanäle zu einem zweiten Kanal geleitet wird, ausgelegt ist
und eine zweite Zone der Kühlplatte für eine Flüssigkeitsströmungsart einer der Arten
- geteilte Strömung, die sich von einem Einlasskanal in mehrere Kanäle verzweigt, wobei die abzweigenden Kanäle die Flüssigkeitsströmung in mindestens zwei unterschiedlichen Richtungen von dem Einlasskanal wegführen,
- vereinigende Strömung, wobei mehrere Kanäle, welche die Strömung in unterschiedlichen Richtungen führen, derart miteinander verbunden sind, dass die Strömung in einen einzelnen Kanal eintritt, oder
- geradlinige Strömung, wobei die Flüssigkeitsströmung von einem ersten Kanal durch eine Vielzahl paralleler Kanäle zu einem zweiten Kanal geleitet wird, ausgelegt ist
und sich die Strömungsart der zweiten Zone von der Strömungsart der ersten Zone unterscheidet.

2. Kühlplattenanordnung nach Anspruch 1, wobei die erste Zone der Kühlplattenanordnung eine Flüssigkeitsströmung der Art geteilte Strömung aufweist und die zweite Zone eine Flüssigkeitsströmung der Art vereinigende Strömung aufweist.

3. Kühlplattenanordnung nach einem der vorhergehenden Ansprüche, wobei die erste Zone mit einem ersten aktiven Bereich der Rechenvorrichtung überlappt und die zweite Zone mit einem zweiten aktiven Bereich der Rechenvorrichtung überlappt.

4. Kühlplattenanordnung nach einem der vorhergehenden Ansprüche, wobei der erste und der zweite aktive Bereich voneinander getrennt sind.

5. Kühlplattenanordnung nach einem der vorhergehenden Ansprüche, wobei sich die erste und die zweite Zone nicht derart überlappen, dass der Auslasskanal der vereinigenden Strömung Flüssigkeit aus der geteilten Strömung aufnimmt.

6. Kühlplattenanordnung nach einem der vorhergehenden Ansprüche, umfassend eine Vielzahl von Einlasskanälen, die zu einem Einlassnetzwerk verbunden ist, und/oder eine Vielzahl von Auslasskanälen, die zu einem Auslassnetzwerk verbunden ist.

7. Kühlplattenanordnung nach Anspruch 6, wobei das Einlassnetzwerk und das Auslassnetzwerk über Mikrokanäle (401) verbunden sind.

8. Kühlplattenanordnung nach einem der vorhergehenden Ansprüche, wobei ein Einlasskanal und ein Auslasskanal auf gegenüberliegenden Seiten eines lokalen Temperaturmaximums eines aktiven Bereichs angeordnet sind.

9. Kühlplattenanordnung nach einem der vorhergehenden Ansprüche, wobei mindestens ein Einlasskanal eine Verengung umfasst, sodass der Querschnittsbereich des Einlasskanals an einer ersten Position durch Verjüngung und/oder stufenweise Verringerung des Querschnittsbereichs größer ist als an einer zweiten Position.

## Revendications

1. Ensemble plaque froide destiné à être utilisé dans un système de refroidissement par liquide pour refroidir un dispositif informatique ayant une pluralité de régions actives à partir desquelles la chaleur est dispersée avec une intensité variable, ledit ensemble plaque froide comprenant :
une plaque froide (105) pour échanger de la chaleur entre ledit dispositif informatique et le liquide de refroidissement dudit système de refroidissement par liquide, ladite plaque froide comprenant une surface extérieure destinée à faire face au dispositif informatique et une surface intérieure opposée conçue pour être en contact avec ledit liquide de refroidissement, ladite surface intérieure comprenant en outre des moyens de guidage pour guider ledit liquide de refroidissement le long de ladite surface intérieure selon un motif prédéfini concentrant le flux de liquide sur une ou plusieurs zones ;
une couche de distribution configurée pour être montée sur ladite surface intérieure de ladite plaque froide, ladite couche de distribution comprenant
- une entrée de liquide (405) à travers laquelle ladite surface intérieure de ladite plaque froide reçoit le liquide de refroidissement en provenance dudit système de refroidissement par liquide, et
- une sortie de liquide (407) à travers laquelle le liquide de refroidissement est évacué à l'opposé de ladite surface intérieure à l'intérieur dudit système de refroidissement par liquide,
ladite entrée de liquide étant en communication de liquide avec un canal d'entrée (403), ledit canal d'entrée et ladite sortie de liquide étant en communication de liquide avec un canal de sortie (409),
de sorte qu'au moins une première zone de l'ensemble plaque froide soit conçue pour un écoulement de liquide présentant l'un des types d'écoulement suivants
- un écoulement divisé qui se ramifie en de multiples canaux à partir d'un canal d'entrée, les canaux de ramification guidant l'écoulement de liquide dans au moins deux directions différentes à l'opposé du canal d'entrée,
- un écoulement réunifié dans lequel de multiples canaux guidant l'écoulement dans différentes directions sont reliés de sorte que l'écoulement pénètre à l'intérieur d'un seul canal, ou
- un écoulement rectiligne dans lequel l'écoulement de liquide est dirigé d'un premier canal vers un second canal à travers une pluralité de canaux parallèles
et une seconde zone de la plaque froide est conçue pour un type d'écoulement de liquide parmi l'un des types suivants
- un écoulement divisé qui se ramifie en de multiples canaux à partir d'un canal d'entrée, les canaux de ramification guidant l'écoulement de liquide dans au moins deux directions différentes à l'opposé du canal d'entrée,
- un écoulement réunifié dans lequel de multiples canaux guidant l'écoulement dans différentes directions sont reliés de sorte que l'écoulement pénètre à l'intérieur d'un seul canal, ou
- un écoulement rectiligne dans lequel l'écoulement de liquide est dirigé d'un premier canal vers un second canal à travers une pluralité de canaux parallèles
et le type d'écoulement de la seconde zone étant différent du type d'écoulement de la première zone.

2. Ensemble plaque froide selon la revendication 1, dans lequel la première zone de l'ensemble plaque froide présente un écoulement de liquide du type écoulement divisé et la seconde zone présente un écoulement de liquide du type écoulement réunifié.

3. Ensemble plaque froide selon l'une quelconque des revendications précédentes, dans lequel la première zone chevauche une première surface active du dispositif informatique et la seconde zone chevauche une seconde surface active du dispositif informatique.

4. Ensemble plaque froide selon l'une quelconque des revendications précédentes, dans lequel la première et la seconde surface active sont séparées l'une de l'autre.

5. Ensemble plaque froide selon l'une quelconque des revendications précédentes, dans lequel la première zone et la seconde zone ne se chevauchent pas de telle sorte que le canal de sortie de l'écoulement réunifié reçoive du liquide en provenance de l'écoulement divisé.

6. Ensemble plaque froide selon l'une quelconque des revendications précédentes comprenant une pluralité de canaux d'entrée reliés dans un réseau d'entrée et/ou une pluralité de canaux de sortie reliés dans un réseau de sortie.

7. Ensemble plaque froide selon la revendication 6, ledit réseau d'entrée et ledit réseau de sortie étant reliés par l'intermédiaire de microcanaux (401).

8. Ensemble plaque froide selon l'une quelconque des revendications précédentes, dans lequel un canal d'entrée et un canal de sortie sont agencés sur des côtés opposés d'un maximum de température local d'une région active.

9. Ensemble plaque froide selon l'une quelconque des revendications précédentes, dans lequel au moins un canal d'entrée comprend un rétrécissement de telle sorte que la section transversale dudit canal d'entrée est plus grande à une première position qu'à une seconde position en effilant et/ou en diminuant par paliers ladite section transversale.
